# EUROPEAN PATENT SPECIFICATION

(11) **EP 4 524 685 B1**
(45) Date of publication and mention of the grant of the patent: **09.12.2026**
(21) Application number: 23196853.8
(22) Date of filing: 12.09.2023
(51) Int. Cl.: G06F 3/01, G01D 21/00, G06F 3/03, G06F 3/04883, G06N 3/08, G06N 20/00

(54) **MEASUREMENT APPLICATION DEVICE, AND METHOD**
MESSANWENDUNGSVORRICHTUNG UND -VERFAHREN
DISPOSITIF D'APPLICATION DE MESURE ET PROCÉDÉ

(43) Date of publication of application: 19.03.2025
(73) Proprietor: Rohde & Schwarz GmbH & Co. KG, 81671 München (DE)
(72) Inventor: Schaefer, Andrew, 82041 Oberhaching (DE)
(74) Representative: Novagraaf Group

(56) References cited:
- CN-B- 106 908 642
- US-A1- 2015 261 298
- US-A1- 2019 324 553
- US-A1- 2021 012 770
- US-A1- 20230 190 136

## Description

### TECHNICAL FIELD

The disclosure relates to a measurement application device, and a respective computer implemented method.

### BACKGROUND

Although applicable to any type of measurement application device, the present disclosure will mainly be described in conjunction with stand-alone measurement devices like oscilloscopes.

Modern measurement application devices comprise a plurality of functions that a user may access. Usually, complex menu trees are provided via a user interface of the measurement application devices for a user to access all possible functions.

Document US 2023/190136 A1 discloses a system for assisting or guiding an arthroscopic surgery (e.g., surgery of the shoulder, knee, hip or spine) or other surgical procedure by providing measurements intraoperatively. Document CN 106 908 642 B discloses a probe that includes a gyroscope sensor for sensing the movement of the probe, and generating movement data of the probe. Document US 2019/324553 A1 discloses an assistant system that may enable the user to interact with it with multi-modal user input (such as voice, text, image, video, motion) in stateful and multi-turn conversations to get assistance. Document US 2015/261298 A1 discloses techniques for enabling a device to recognize a new gesture by monitoring the sensor output of any sensors provided by the device while the user performs the gesture, optionally requesting repeated gesture performances until reaching a recognition confidence. Document US 2021/012770 A1 discloses a device for multi-modal user input that includes a processor configured to process first data received from a first input device. The first data indicates a first input from a user based on a first input mode. The first input corresponds to a command. The processor is configured to send a feedback message to an output device based on processing the first data.

There is a need for simplifying control of measurement application devices.

### SUMMARY

The present invention is defined by the appended independent claims; the dependent claims set out advantageous embodiments. It shall also be noted that the references made through this description to an "embodiment", "example", "aspect" or "configuration" may point to alternative aspects related to the invention but do not necessarily correspond to embodiments of the claimed invention. It is to be understood that other examples can be practiced, and various modifications and structural changes can be made to these actual embodiments of the invention without departing from the scope of the claims, as would be understood by one of ordinary skill in the art.

The above stated problem is solved by the features of the independent claims. It is understood, that independent claims of a claim category may be formed in analogy to the dependent claims of another claim category.

The present disclosure is based on the finding that handling, and especially configuring, a modern measurement application device may be a cumbersome task for users. Especially, the plurality of different processing or configuration options may make it difficult for a user to remember where or how to access the respective processing or configuration option.

Inexperienced users may even lack the knowledge about the presence of specific processing or configuration options.

The present disclosure, therefore, provides the measurement application device that comprises a signal processing module, a user interface, and a processor.

The signal processing module is that part of the measurement application device that performs any kind of signal acquisition of measurement signals, signal generation of measurement signals or signal processing functions on measurement signals. Generally, the signal processing module may acquire measurement signals to be measured from a device under test, also called DUT. The signal processing module may also generate measurement signals e.g., for driving an input port of a device under test. Exemplarily, for an oscilloscope, the signal processing module may e.g., comprise the vertical system, the triggering system, the horizontal system, and the signal processing section of an oscilloscope.

Generally, a measurement application device according to the present disclosure may comprise any device that may be used in a measurement application to acquire an input signal or to generate an output signal, or to perform additional or supporting functions in a measurement application. A measurement application device may also comprise or be implemented as program application or program applications, also called measurement program application or measurement program applications, that may be executed on a computer device and that may communicate with other measurement application devices in order to perform a measurement task. A measurement application, also called measurement setup, may e.g., comprise at least one or multiple different measurement application devices for performing electric, magnetic, or electromagnetic measurements, especially on single devices under test. Such electric, magnetic, or electromagnetic measurements may e.g., be performed in a measurement laboratory or in a production facility in the respective production line. An exemplary measurement application or measurement setup may serve to qualify the single devices under test i.e., to determine the proper electrical operation of the respective devices under test.

Measurement application devices to this end may comprise at least one signal acquisition section for acquiring electric, magnetic, or electromagnetic signals to be measured from a device under test, or at least one signal generation section for generating electric, magnetic, or electromagnetic signals that may be provided to the device under test. Such a signal acquisition section may comprise, but is not limited to, a front-end for acquiring, filtering, and attenuating or amplifying electrical signals. The signal generation section may comprise, but is not limited to, respective signal generators, amplifiers, and filters. In embodiments, the signal acquisition is performed via the signal acquisition section in a wired or contact-based manner or fashion. To this end, a respective measurement probe may be coupled to the measurement application device via a respective cable. In embodiments, the signal generation and emission are performed via the signal generation section in a wired or contact-based manner or fashion. To this end, a respective signal output probe may be coupled to the measurement application device via a respective cable, or the signal may be output directly via the cable e.g., to a device under test.

Further, when acquiring signals, measurement application devices may comprise a signal processing section that may process the acquired signals. Processing may comprise converting the acquired signals from analog to digital signals, and any other type of digital signal processing, for example, converting signals from the time-domain into the frequency-domain.

The measurement application devices may also comprise a user interface to display the acquired signals to a user and allow a user to control the measurement application devices. Of course, a housing may be provided that comprises the elements of the measurement application device. It is understood, that further elements, like power supply circuitry, and communication interfaces may be provided.

A measurement application device may be a stand-alone device that may be operated without any further element in a measurement application to perform tests on a device under test. Of course, communication capabilities may also be provided for the measurement application device to interact with other measurement application devices.

A measurement application device may comprise, for example, a signal acquisition device e.g., an oscilloscope, especially a digital oscilloscope, a spectrum analyzer, or a vector network analyzer. Such a measurement application device may also comprise a signal generation device e.g., a signal generator, especially an arbitrary signal generator, also called arbitrary waveform generator, or a vector signal generator. Further possible measurement application devices comprise devices like calibration standards, or measurement probe tips.

Of course, at least some of the possible functions, like signal acquisition and signal generation, may be combined in a single measurement application device.

In embodiments, the measurement application device may comprise pure data acquisition devices that are capable of acquiring an input signal and of providing the acquired input signal as digital input signal to a respective data storage or application server. Such pure data acquisition devices not necessarily comprise a user interface or display. Instead, such pure data acquisition devices may be controlled remotely e.g., via a respective data interface, like a network interface or a USB interface. The same applies to pure signal generation devices that may generate an output signal without comprising any user interface or configuration input elements. Instead, such signal generation devices may be operated remotely via a data connection.

The user interface of the measurement application device according to the present disclosure serves at least for acquiring gesture-based user input. Gesture-based in this regard refers to any user input that may be freely provided by a user e.g., by painting with one or more fingers on a touch screen, or by moving an object, like a probe or a body part, especially a hand, or a finger, midair. Generally, gesture-based user input refers to a user input that needs to be interpreted und does not directly actuate a user input element, either a real user input element, or a virtual user input element on a screen. Real user input elements may comprise, but are not limited to, e.g., knobs, switches, and sliders. Virtual user input elements may comprise, but are not limited to, e.g., knobs, switches, and sliders drawn on a screen, especially a touch-screen, of the measurement device.

In contrast to such real or virtual user input elements, the gesture-based user input may be provided by a user independently of any present user input elements e.g., by drawing on the whole surface of a display of the measurement application device. A user may e.g., draw a quick sketch of a function, or the first letters of that function.

In order to analyzer and process such gesture-based user input, the measurement application device further comprises a processor. The processor to this end executes a machine learning algorithm. The machine learning algorithm is provided with the gesture-based user input, analyzes the gesture-based user input, and outputs respective control or configuration information.

The machine learning algorithm may, therefore, be trained to recognize a certain gesture-based user input, and to associate the respective gesture-based user input with a specific control or configuration information. Such control or configuration information may be output by the machine learning algorithm e.g., to a control unit in the measurement application device that controls or configures the signal processing module accordingly.

The expression "control information" in this context refers to information that indicates how the signal processing module should be controlled. Such information may e.g., indicate that a specific function should be activated in the signal processing module, or that a specific function should be deactivated in the signal processing module. Such functions may refer to the acquisition of a measurement signal, to the generation of a measurement signal, and to additional processing functions being applied to an acquired or generated measurement signal.

The expression "configuration information" in this context refers to information that indicates how to configure the signal processing module. Configuring the signal processing module refers to setting parameters in the signal processing module that may influence e.g., the generation of a measurement signal, the acquisition of a measurement signal, or the application of processing functions to a measurement signal.

With the machine learning algorithm providing the control or configuration information, it is possible to provide a user with the ability to access different functions of the measurement application device easily and quickly, without any knowledge about where to find the respective functions in the user interface of the measurement application device. Control of the measurement application device is, therefore, simplified.

The machine learning algorithm may comprise any type of algorithm from the field of machine learning algorithms that is adequate for recognizing the gesture-based user input. The machine learning algorithm may, especially, comprise trained artificial intelligence algorithms, that are trained or may be trained to associate the gesture-based user input with respective control or configuration information. The machine learning algorithm may e.g., comprise neural network-based algorithms that may easily be trained to recognize specific gesture-based user input and associate such gesture-based user input with respective control or configuration information.

In embodiments, the machine learning algorithm may directly output a control or configuration information. In other embodiments, the machine learning algorithm may output an identifier for the gesture-based user input, and the processor may comprise a further function that associates the identifier with respective control or configuration information. Such a function may comprise using a look-up-table for associating the identifier with the control or configuration information.

Generally, the processor may comprise or may be provided in or as part of at least one of a dedicated processing element e.g., a processing unit, a microcontroller, a field programmable gate array, FPGA, a complex programmable logic device, CPLD, an application specific integrated circuit, ASIC, or the like. A respective program or configuration may be provided to implement the required functionality. The processor may at least in part also be provided as a computer program product comprising computer readable instructions that may be executed by a processing element. In a further embodiment, the processor may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them.

In addition, it is understood, that any required supporting or additional hardware may be provided like e.g., a power supply circuitry and clock generation circuitry.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to the measurement application device can be combined in all variations with each other and the disclosure of the description is not limited to the claim dependencies as specified in the claim set. Further, the features of the other independent claims may be combined with any of the features of the dependent claims relating to the measurement application device in all variations, wherein respective method steps perform the function of the respective apparatus elements.

In an embodiment, which can be combined with all other embodiments of the measurement application device mentioned above or below, the user interface may comprise a touchscreen, and the machine learning algorithm may be configured to analyze gesture-based user input received from a user via the touchscreen.

With a touchscreen, the user may draw his gesture-based user input directly on the touchscreen. The advantage of a touchscreen is that the user input may directly be acquired.

The machine learning algorithm may in such an embodiment be adapted to perform a kind of optical character recognition, since the gesture-based user input is received as a trace on the touchscreen, and may be seen as a type of drawn character.

In another embodiment, which can be combined with all other embodiments of the measurement application device mentioned above or below, the user interface may comprise at least one of a movement sensor, and a camera, and the machine learning algorithm may be configured to analyze gesture-based user input acquired via the at least one of the movement sensor, and the camera.

With a movement sensor, or a camera, the gesture-based user input may be indirectly acquired. A user may e.g., perform the gesture in midair, and the movement sensor may acquire the gesture-based user input e.g., in the form of a trace of the user's movement.

In embodiments, the camera, or multiple cameras, may record the user while performing the gesture. A respective image or video analyzer may determine the gesture-based user input from the recorded image(s) or video, and provide the gesture-based user input to the processor, especially the machine learning algorithm.

In embodiments, the image or video analyzer may be integrated into the machine learning algorithm. In such embodiments, the machine learning algorithm may be provided directly with the image(s) or video recorded by the camera.

In a further embodiment, which can be combined with all other embodiments of the measurement application device mentioned above or below, the machine learning algorithm may be configured to output exactly one control information, or to output exactly one configuration information based on the gesture-based user input.

After receiving a gesture-based user input, the machine learning algorithm may directly output a single configuration information, or control information. The machine learning algorithm may e.g., output the configuration information, or control information that is associated with the received gesture-based user input.

In embodiments, the machine learning algorithm may determine a confidence score, also called classification threshold, and output the respective configuration information, or control information, if the determined confidence score for the received gesture-based user input is above a predetermined value.

In the measurement application device, this single configuration information, or control information may be directly applied or activated.

In another embodiment, which can be combined with all other embodiments of the measurement application device mentioned above or below, the machine learning algorithm may be configured to output at least two suggestions of control information, or configuration information based on the gesture-based user input.

As alternative to the above-explained direct application of the configuration information, or control information, the machine learning algorithm may also provide, or output at least two suggestions of configuration information, or control information that the user may want to activate with the gesture-based user input.

Outputting at least two suggestions may be combined with the direct application of only one configuration information, or control information.

If for example, the confidence score is high enough i.e., above a predetermined threshold, the respective single configuration information, or control information may be directly applied.

If, on the other hand, the confidence score is below a predetermined threshold, the machine learning algorithm may output at least two suggestions. The machine learning algorithm may e.g., output at least two suggestions of configuration information, or control information for those gesture-based user inputs that are identified with the highest confidence score.

In a further embodiment, which can be combined with all other embodiments of the measurement application device mentioned above or below, the processor may be configured to train the machine learning algorithm based on user feedback regarding the suggestions.

After providing the user with at least two suggestions regarding possible configuration information, or control information, the user may select one of the presented options as the correct options.

The processor may use such a user feedback to perform further training of the machine learning algorithm. The set of the respective user input, with the user selection may serve as a respective training data set.

In another embodiment, which can be combined with all other embodiments of the measurement application device mentioned above or below, the processor may be configured to output a user request to a user for repeating the gesture-based user input if the machine learning algorithm calculates a confidence score for the gesture-based user input that is below a predetermined threshold.

If a user provides an unclear gesture-based user input, such a gesture-based user input may not reliably be analyzed by the machine learning algorithm. This usually may result in a low confidence score. The confidence score indicates a level of confidence for the analysis performed by the machine learning algorithm, wherein a low confidence score may indicate that there is a high chance that the analysis may be wrong, while a high confidence score may indicate that there is a high chance of the analysis being right.

In case that the confidence score is below a predetermined threshold, the user may, therefore, be requested to repeat the gesture-based user input.

Although not explicitly stated, the user request for repeating the gesture-based user input may be provided to the user via a display of the measurement application device, or via any other output device, like a speaker.

In a further embodiment, which can be combined with all other embodiments of the measurement application device mentioned above or below, the machine learning algorithm may be configured to output suggestions for at least one control information, or configuration information for association with a gesture-based user input based on the respective gesture-based user input in a configuration operating mode of the processor.

The processor may be switched into a configuration operating mode. In the configuration operating mode, a user may provide gesture-based user input, and associate the respective gesture-based user input with a respective configuration information, or control information.

In the configuration operating mode, a user may select the configuration information, or control information, and then provide the respective gesture-based user input.

In embodiments, the user may also provide the gesture-based user input first. In such embodiments, the machine learning algorithm may provide respective suggestions for associating the respective gesture-based user input with a respective configuration information, or control information.

The machine learning algorithm may e.g., suggest the configuration information, or control information that was already associated with similar gesture-based user input in the past e.g., by other users.

In a further embodiment, which can be combined with all other embodiments of the measurement application device mentioned above or below, in the configuration operating mode of the processor, the processor may be configured to request a user to repeat a gesture-based user input for training the machine learning algorithm.

A user may, in the configuration operating mode of the processor, define gestures or gesture-based user input and associate this gesture-based user input with a respective configuration information, or control information.

Especially, for training the machine learning algorithm, the user may be requested to repeat the respective gesture-based user input as many times as adequate for training the machine learning algorithm.

Although not explicitly stated, the user request for repeating the gesture-based user input may be provided to the user via a display of the measurement application device, or via any other output device, like a speaker.

In embodiments, the machine learning algorithm may comprise a pre-trained machine learning algorithm that is generally trained to identify or analyze gesture-based user input. For application in the measurement application device, such a generally trained machine learning algorithm may be fine-tuned or re-trained to identify or analyze the gesture-based user input that may be provided by users to the measurement application device.

By training the machine learning algorithm to analyze individual gesture-based user input that a user may provide to the measurement application device, it is possible for a user to freely define gesture-based user input and associate the user-defined gesture-based user input with respective configuration information, or control information.

By using a trained machine learning algorithm, individual characteristics of the gesture-based user input may be handled correctly, and the correct configuration information, or control information may still be determined, even if the gesture-based user input varies slightly from user to user, or between two gesture-based user inputs provided by the same user.

In another embodiment, which can be combined with all other embodiments of the measurement application device mentioned above or below, the measurement application device may further comprise a measurement probe coupled to the signal processing module, wherein the processor is configured to configure the measurement probe based on the configuration information, or control information.

Measurement probes are usually externally connected to the measurement application device i.e., the signal processing module of the measurement application device. Such measurement probes may comprise a plurality of configuration options that a user may usually configure via a user input on the measurement probe. Further, measurement probes may comprise a data interface to the measurement application device.

Consequently, the gesture-based user input may also be used to define configuration information, or control information for the measurement probe. The processor may, therefore, configure the measurement probe based on such a gesture-based user input via a respective data interface.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a measurement application device according to the present disclosure;
Figure 2 shows a block diagram of another embodiment of a measurement application device according to the present disclosure;
Figure 3 shows a block diagram of another embodiment of a measurement application device according to the present disclosure;
Figure 4 shows a block diagram of another embodiment of a measurement application device according to the present disclosure;
Figure 5 shows a block diagram of another embodiment of a measurement application device according to the present disclosure;
Figure 6 shows a block diagram of another embodiment of a measurement application device according to the present disclosure;
Figure 7 shows a block diagram of an oscilloscope that may be an embodiment of a measurement application device according to the present disclosure;
Figure 8 shows a block diagram of an oscilloscope that may be an embodiment of a measurement application device according to the present disclosure; and
Figure 9 shows examples of gesture-based user input as it may be used with the measurement application device and method according to the present disclosure.

In the figures like reference signs denote like elements unless stated otherwise.

### DETAILED DESCRIPTION OF THE DRAWINGS

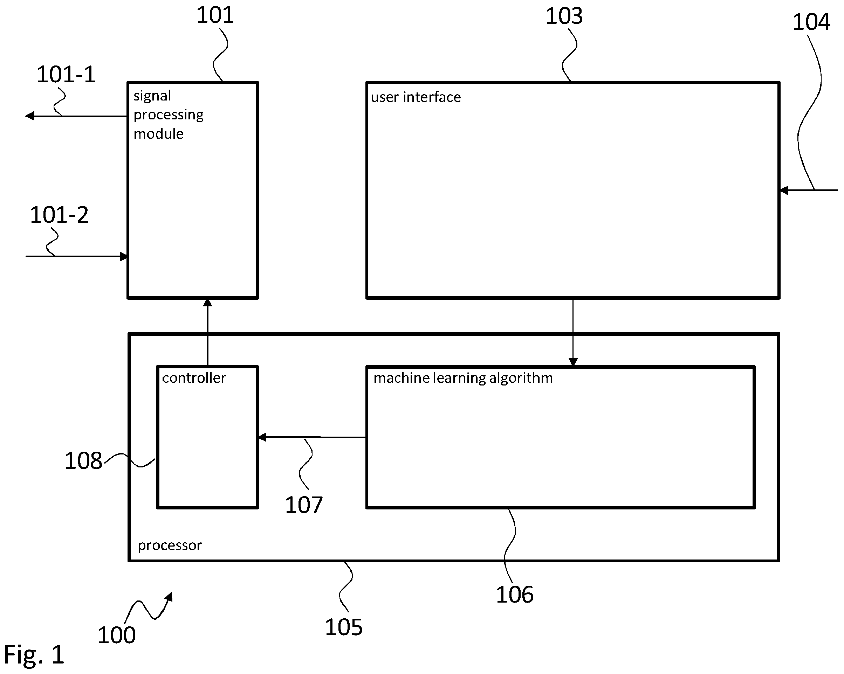

Figure 1 shows a block diagram of a measurement application device 100. The measurement application device 100 comprises a signal processing module 101, and a user interface 103. The signal processing module 101, and the user interface 103 are coupled to a processor 105. The processor 105 comprises a machine learning algorithm 106, and a controller 108. The explanations provided in this disclosure regarding any feature of any other embodiment of the measurement application device may be combined with the explanations regarding the measurement application device 100 mutatis mutandis.

During operation of the measurement application device 100, the signal processing module 101 at least one of generates measurement signals 102-1, and acquires measurement signals 102-2. As explained above, the signal processing module 101 may comprise the vertical and horizontal system of a measurement application device, like an oscilloscope for acquiring measurement signals, and/or the respective elements for generating measurement signals 101-1.

The user interface 103 acquires gesture-based user input 104. Such gesture-based user input 104 may be drawn e.g., with a finger, or with a mouse that is coupled to the measurement application device 100.

Alternatively, the gesture-based user input 104 may be provided as a gesture in mid-air. In such embodiments, the user interface 103 may comprise at least one of a movement sensor, and a camera (not explicitly shown).

The processor 105 executes a machine learning algorithm 106. This machine learning algorithm 106 analyzes the received gesture-based user input 104, and outputs respective control information 107 for controlling the signal processing module 101 or configuration information 107 for configuration of the signal processing module 101.

In the processor 105 a controller 108 or control function is provided that receives the control, or configuration information 107 and controls, or configures the signal processing module 101 accordingly. Of course, in other embodiments, the controller 108 may also be provided e.g., in the signal processing module 101, and the control, or configuration information 107 may be provided directly to the signal processing module 101.

Generally, the controller 108 may be provided as hardware or software unit. The controller 108 may e.g., be provided as additional function of an operating system or firmware that is executed in the processor 105.

As explained above, the machine learning algorithm 106 may comprise any algorithm that may be trained to identify the gesture-based user input 104 and output at least a respective identification. In such an embodiment, the identification of the gesture-based user input 104 may implement the control, or configuration information 107. The controller 108 may then relate the identification to a respective function in the measurement application device 100 and control the signal processing module 101 accordingly.

In other embodiments, the machine learning algorithm 106 may directly output the respective control, or configuration information 107 to the signal processing module 101 for configuring, or controlling the signal processing module 101.

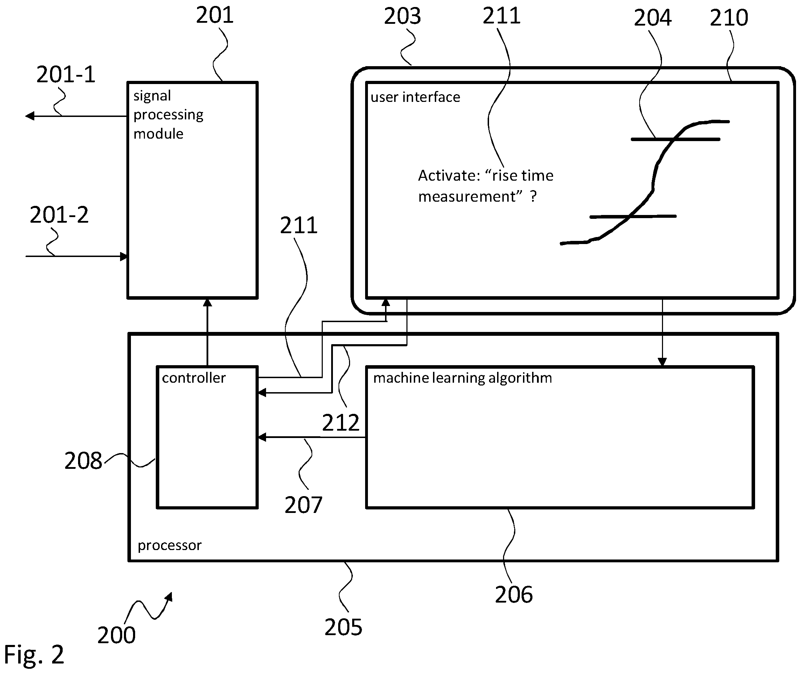

Figure 2 shows a block diagram of an embodiment of a measurement application device 200. The measurement application device 200 is based on the measurement application device 100, The measurement application device 200, therefore, comprises a signal processing module 201, and a user interface 203. The signal processing module 201, and the user interface 203 are coupled to a processor 205. The processor 205 comprises a machine learning algorithm 206, and a controller 208. The explanations provided in this disclosure regarding any feature of any other embodiment of the measurement application device may be combined with the explanations regarding the measurement application device 200 mutatis mutandis.

In the measurement application device 200, the user interface 203 comprises a touchscreen 210. A user may use the touchscreen 210 to draw a gesture-based user input 204 onto the touchscreen 210. The gesture-based user input 204 is then analyzed by the machine learning algorithm 206 to determine the control, or configuration information 207. In the example of the measurement application device 200, the gesture-based user input 204 is shown as S-shaped curve with two horizontal lines in the upper and lower sections. Such a gesture-based user input 204 may e.g., refer to activation of the rise time measurement function.

Optionally, the touchscreen 210 shows a suggestion 211 of a possible control, or configuration information 207. In the measurement application device 200, the machine learning algorithm 206 provides the control, or configuration information 207 to the controller 208, and the controller 208 provides the suggestion 211 to a user via the touchscreen 210. In other embodiments, the machine learning algorithm 206 may provide the suggestion 211 directly.

The user may then provide a respective user feedback 212 for accepting or rejecting the suggestion 211, and, therefore, the control, or configuration information 207.

In the example of measurement application device 200, only a single suggestion 211 is shown on the touchscreen 210, which a user may accept of reject. This may be the case, if the machine learning algorithm 206 determines the control, or configuration information 207 with a high enough confidence score.

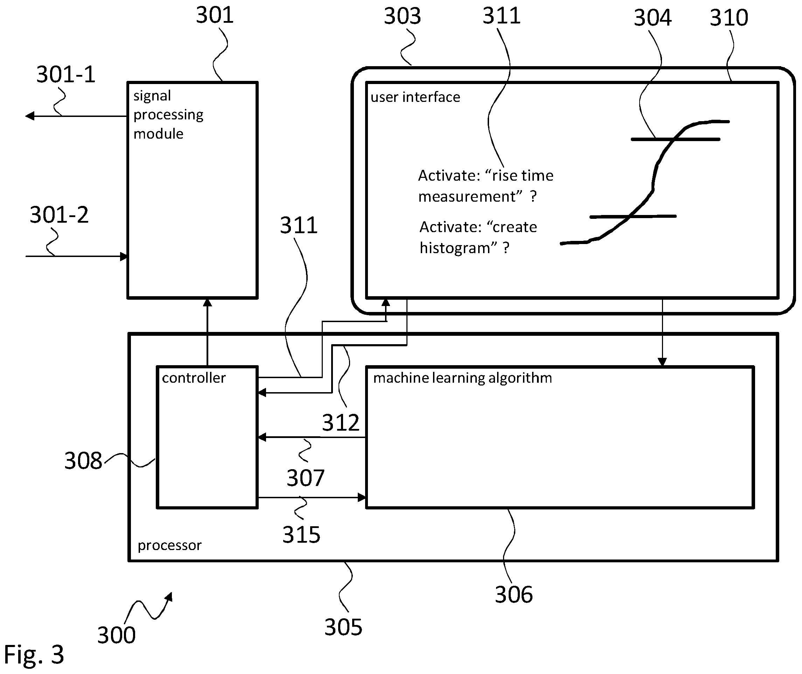

Figure 3 shows a block diagram of an embodiment of a measurement application device 300. The measurement application device 300 is based on the measurement application device 200, The measurement application device 300, therefore, comprises a signal processing module 301, and a user interface 303. The signal processing module 301, and the user interface 303 are coupled to a processor 305. The processor 305 comprises a machine learning algorithm 306, and a controller 308. The user interface 303 comprises a touchscreen 310. A user may use the touchscreen 310 to draw a gesture-based user input 304 onto the touchscreen 310. The gesture-based user input 304 is then analyzed by the machine learning algorithm 306 to determine the control, or configuration information 307. The explanations provided in this disclosure regarding any feature of any other embodiment of the measurement application device may be combined with the explanations regarding the measurement application device 300 mutatis mutandis.

The touchscreen 310 shows two exemplary suggestion 311 of possible control, or configuration information 307. The machine learning algorithm 306 may provide multiple suggestions 311, or sets of control, or configuration information 307, e.g., if the confidence score for the analyzed gesture-based user input 304 is below a predetermined threshold.

A user may provide a user feedback 312 that selects one of the suggestions 311. The controller 308 may control the signal processing module 301 accordingly, as described above.

Further, the controller 308 may optionally also generate training data 315 from the user feedback 312, and provide the training data 315 to the machine learning algorithm 306 for further training the machine learning algorithm 306 during normal operation of the measurement application device 300.

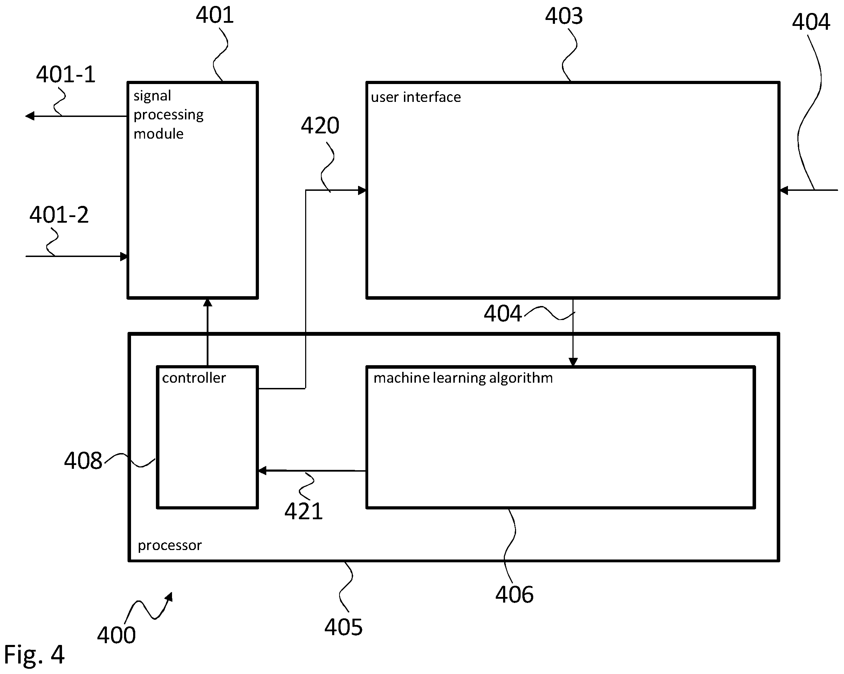

Figure 4 shows a block diagram of an embodiment of a measurement application device 400. The measurement application device 400 is based on the measurement application device 100, The measurement application device 400, therefore, comprises a signal processing module 401, and a user interface 403. The signal processing module 401, and the user interface 403 are coupled to a processor 405. The processor 405 comprises a machine learning algorithm 406, and a controller 408. The explanations provided in this disclosure regarding any feature of any other embodiment of the measurement application device may be combined with the explanations regarding the measurement application device 400 mutatis mutandis.

The measurement application device 400 shows how a configuration operating mode of the processor 405 may be implemented. In the configuration operating mode, the processor 405 is configured to receive a confidence score 421 from the machine learning algorithm 406 for a gesture-based user input 404 provided by a user. If the confidence score 421 is below a predetermined threshold, the processor 405 may display a user request 420 on the user interface 403 that requests the user to repeat the gesture-based user input 404.

The machine learning algorithm 406 may then perform a training with multiple gesture-based user inputs 404, until a sufficiently high confidence score 421 is achieved.

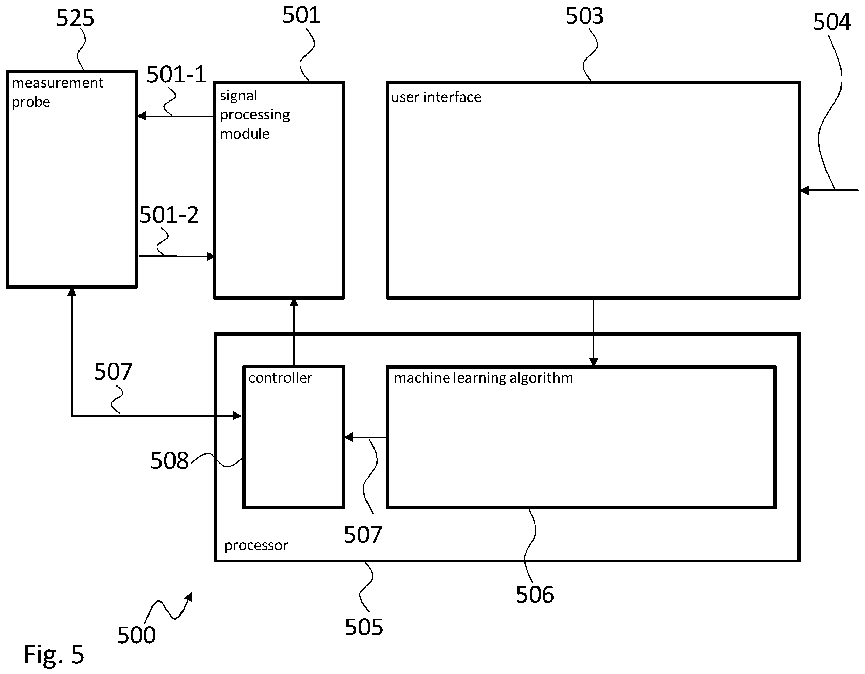

Figure 5 shows a block diagram of an embodiment of a measurement application device 500. The measurement application device 500 is based on the measurement application device 100, The measurement application device 500, therefore, comprises a signal processing module 501, and a user interface 503. The signal processing module 501, and the user interface 503 are coupled to a processor 505. The processor 505 comprises a machine learning algorithm 506, and a controller 508. The explanations provided in this disclosure regarding any feature of any other embodiment of the measurement application device may be combined with the explanations regarding the measurement application device 500 mutatis mutandis.

The measurement application device 500 further comprises a measurement probe 525 that is coupled to the signal processing module 501 for outputting measurement signals 501-1, or for receiving measurement signals 501-2. The measurement probe 525 may e.g., be coupled to the signal processing module 501 via a coaxial connection.

In addition, a data connection may be provided between the measurement probe 525, and the controller 508 for configuring and controlling the measurement probe 525.

In the measurement application device 500, the gesture-based user input 504 may refer to the signal processing module 501, and the measurement probe 525.

If a gesture-based user input 504 regarding the measurement probe 525 is received, the machine learning algorithm 506 may, therefore, output respective control, or configuration information 507 for the measurement probe 525.

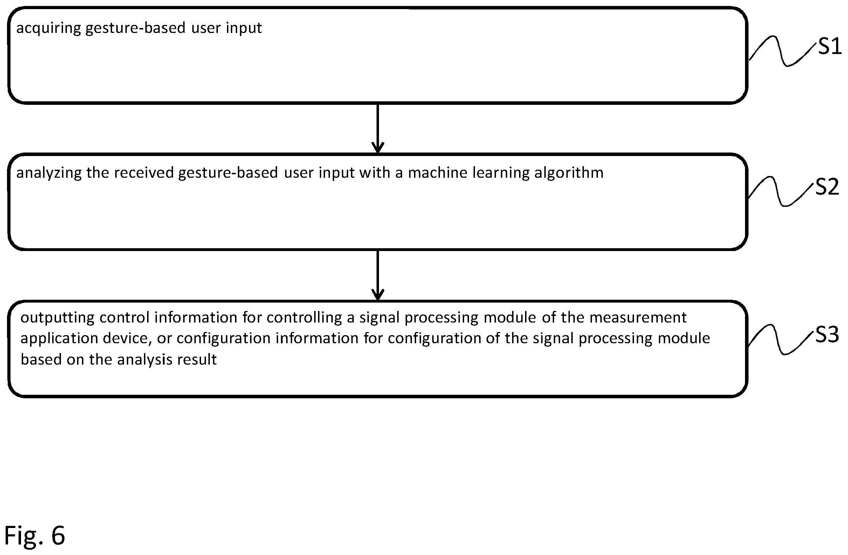

Figure 6 shows a flow diagram of a computer implemented method for operating a measurement application device 100, 200, 300, 400, 500.

The method comprises acquiring S1 gesture-based user input 104, 204, 304, 404, 504, analyzing S2 the received gesture-based user input 104, 204, 304, 404, 504 with a machine learning algorithm 106, 206, 306, 406, 506, and outputting S3 control information 107, 207, 307, 407, 507 for controlling a signal processing module 101, 201, 301, 401, 501 of the measurement application device 100, 200, 300, 400, 500, or configuration information 107, 207, 307, 407, 507 for configuration of the signal processing module 101, 201, 301, 401, 501 based on the analysis result.

In embodiments, a measurement probe 525 that is coupled to the measurement application device 100, 200, 300, 400, 500 may be configured based on the configuration information 107, 207, 307, 407, 507, or control information 107, 207, 307, 407, 507.

The gesture-based user input 104, 204, 304, 404, 504 may be acquired via a touchscreen 210, 310. In addition, or as alternative, the gesture-based user input 104, 204, 304, 404, 504 may be acquired via at least one of a movement sensor, and a camera.

The machine learning algorithm 106, 206, 306, 406, 506 may in embodiments output exactly one control information 107, 207, 307, 407, 507, or exactly one configuration information 107, 207, 307, 407, 507 based on the gesture-based user input 104, 204, 304, 404, 504. Especially, if a confidence score 421 for the gesture-based user input 104, 204, 304, 404, 504 is below a predetermined threshold, the machine learning algorithm 106, 206, 306, 406, 506 may output at least two suggestions 211, 311 of control information 107, 207, 307, 407, 507, or configuration information 107, 207, 307, 407, 507 based on the gesture-based user input 104, 204, 304, 404, 504. The machine learning algorithm 106, 206, 306, 406, 506 may be trained based on user feedback 212, 312 regarding the suggestions 211, 311.

A user request 420 may also be provided to a user for repeating the gesture-based user input 104, 204, 304, 404, 504 if the machine learning algorithm 106, 206, 306, 406, 506 calculates a confidence score 421 for the gesture-based user input 104, 204, 304, 404, 504 that is below a predetermined threshold.

In a configuration operating mode, the machine learning algorithm 106, 206, 306, 406, 506 may output suggestions for at least one control information 107, 207, 307, 407, 507, or configuration information 107, 207, 307, 407, 507 for association with a gesture-based user input 104, 204, 304, 404, 504 based on the respective gesture-based user input 104, 204, 304, 404, 504.

In the configuration operating mode, a user may, further, be requested to repeat a gesture-based user input 104, 204, 304, 404, 504 for training the machine learning algorithm 106, 206, 306, 406, 506.

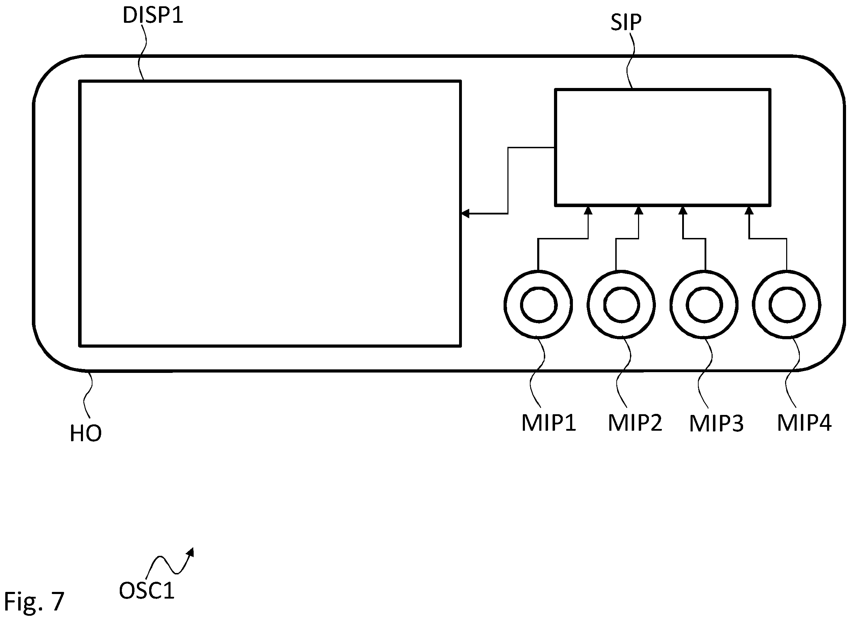

Figure 7 shows a block diagram of an oscilloscope OSC1 that may be an implementation of an embodiment of a measurement application device according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user.

Although not explicitly shown, it is understood, that the oscilloscope OSC1 may also comprise signal outputs. Such signal outputs may for example serve to output calibration signals. Such calibration signals allow calibrating the measurement setup prior to performing any measurement. The process of calibrating and correcting any measurement signals based on the calibration may also be called de-embedding and may comprise applying respective algorithms on the measured signals.

In the oscilloscope OSC1 the signal processor SIP or an additional processing element may perform the function of processor according to the present disclosure, or may implement the processor.

In embodiments, a communication interface may be provided in the oscilloscope OSC1 for communication with other measurement application devices.

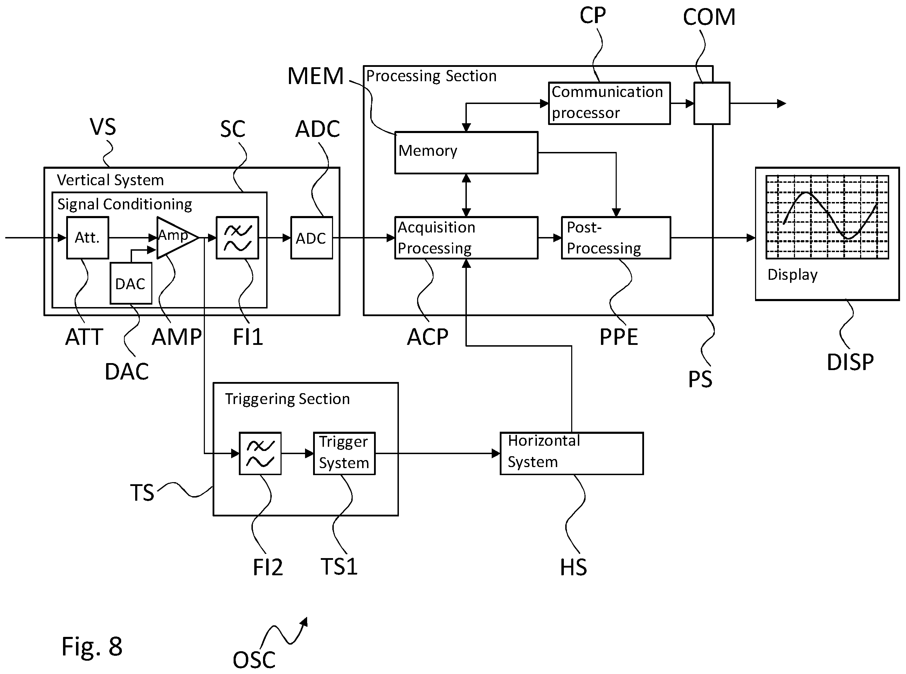

Figure 8 shows a block diagram of another oscilloscope OSC that may be an implementation of a measurement application device according to the present disclosure. The oscilloscope OSC is implemented as a digital oscilloscope. However, the present disclosure may also be implemented with any other type of oscilloscope.

The oscilloscope OSC exemplarily comprises five general sections, the vertical system VS, the triggering section TS, the horizontal system HS, the processing section PS, and the display DISP. It is understood, that the partitioning into five general sections is a logical partitioning and does not limit the placement and implementation of any of the elements of the oscilloscope OSC in any way.

The vertical system VS mainly serves for offsetting, attenuating, and amplifying a signal to be acquired. The signal may for example be modified to fit in the available space on the display DISP or to comprise a vertical size as configured by a user.

To this end, the vertical system VS comprises a signal conditioning section SC with an attenuator ATT and a digital-to-analog-converter DAC that are coupled to an amplifier AMP. The amplifier AMP is coupled to a filter FI1, which in the shown example is provided as a low pass filter. The vertical system VS also comprises an analog-to-digital converter ADC that receives the output from the filter FI1 and converts the received analog signal into a digital signal.

The attenuator ATT and the amplifier AMP serve to scale the amplitude of the signal to be acquired to match the operation range of the analog-to-digital converter ADC. The digital-to-analog-converter DAC serves to modify the DC component of the input signal to be acquired to match the operation range of the analog-to-digital converter ADC. The filter FI1 serves to filter out unwanted high frequency components of the signal to be acquired.

The triggering section TS operates on the signal as provided by the amplifier AMP. The triggering section TS comprises a filter FI2, which in this embodiment is implemented as a low pass filter. The filter FI2 is coupled to a trigger system TS1.

The triggering section TS serves to capture predefined signal events and allows the horizontal system HS to e.g., display a stable view of a repeating waveform, or to simply display waveform sections that comprise the respective signal event. It is understood, that the predefined signal event may be configured by a user via a user input of the oscilloscope OSC.

Possible predefined signal events may for example include, but are not limited to, when the signal crosses a predefined trigger threshold in a predefined direction i.e., with a rising or falling slope. Such a trigger condition is also called an edge trigger. Another trigger condition is called "glitch triggering" and triggers, when a pulse occurs in the signal to be acquired that has a width that is greater than or less than a predefined amount of time.

In order to allow an exact matching of the trigger event and the waveform that is shown on the display DISP, a common time base may be provided for the analog-to-digital converter ADC and the trigger system TS1.

It is understood, that although not explicitly shown, the trigger system TS1 may comprise at least one of configurable voltage comparators for setting the trigger threshold voltage, fixed voltage sources for setting the required slope, respective logic gates like e.g., a XOR gate, and FlipFlops to generate the triggering signal.

The triggering section TS is exemplarily provided as an analog trigger section. It is understood, that the oscilloscope OSC may also be provided with a digital triggering section. Such a digital triggering section will not operate on the analog signal as provided by the amplifier AMP but will operate on the digital signal as provided by the analog-to-digital converter ADC.

A digital triggering section may comprise a processing element, like a processor, a DSP, a CPLD, an ASIC or an FPGA to implement digital algorithms that detect a valid trigger event.

The horizontal system HS is coupled to the output of the trigger system TS1 and mainly serves to position and scale the signal to be acquired horizontally on the display DISP.

The oscilloscope OSC further comprises a processing section PS that implements digital signal processing and data storage for the oscilloscope OSC. The processing section PS comprises an acquisition processing element ACP that is couple to the output of the analog-to-digital converter ADC and the output of the horizontal system HS as well as to a memory MEM and a post processing element PPE.

The acquisition processing element ACP manages the acquisition of digital data from the analog-to-digital converter ADC and the storage of the data in the memory MEM. The acquisition processing element ACP may for example comprise a processing element with a digital interface to the analog-to-digital converter ADC2 and a digital interface to the memory MEM. The processing element may for example comprise a microcontroller, a DSP, a CPLD, an ASIC or an FPGA with respective interfaces. In a microcontroller or DSP, the functionality of the acquisition processing element ACP may be implemented as computer readable instructions that are executed by a CPU. In a CPLD or FPGA the functionality of the acquisition processing element ACP may be configured in to the CPLD or FPGA opposed to software being executed by a processor.

The processing section PS further comprises a communication processor CP and a communication interface COM.

The communication processor CP may be a device that manages data transfer to and from the oscilloscope OSC. The communication interface COM for any adequate communication standard like for example, Ethernet, WIFI, Bluetooth, NFC, an infra-red communication standard, and a visible-light communication standard.

The communication processor CP is coupled to the memory MEM and may use the memory MEM to store and retrieve data.

Of course, the communication processor CP may also be coupled to any other element of the oscilloscope OSC to retrieve device data or to provide device data that is received from the management server.

The post processing element PPE may be controlled by the acquisition processing element ACP and may access the memory MEM to retrieve data that is to be displayed on the display DISP. The post processing element PPE may condition the data stored in the memory MEM such that the display DISP may show the data e.g., as waveform to a user. The post processing element PPE may also realize analysis functions like cursors, waveform measurements, histograms, or math functions.

The display DISP controls all aspects of signal representation to a user, although not explicitly shown, may comprise any component that is required to receive data to be displayed and control a display device to display the data as required.

It is understood, that even if it is not shown, the oscilloscope OSC may also comprise a user interface for a user to interact with the oscilloscope OSC. Such a user interface may comprise dedicated input elements like for example knobs and switches. At least in part the user interface may also be provided as a touch sensitive display device.

In the oscilloscope OSC, any one of the processing elements in the processing section PS or an additional processing element may perform the function processor according to the present disclosure.

It is understood, that all elements of the oscilloscope OSC that perform digital data processing may be provided as dedicated elements. As alternative, at least some of the above-described functions may be implemented in a single hardware element, like for example a microcontroller, DSP, CPLD or FPGA. Generally, the above-describe logical functions may be implemented in any adequate hardware element of the oscilloscope OSC and not necessarily need to be partitioned into the different sections explained above.

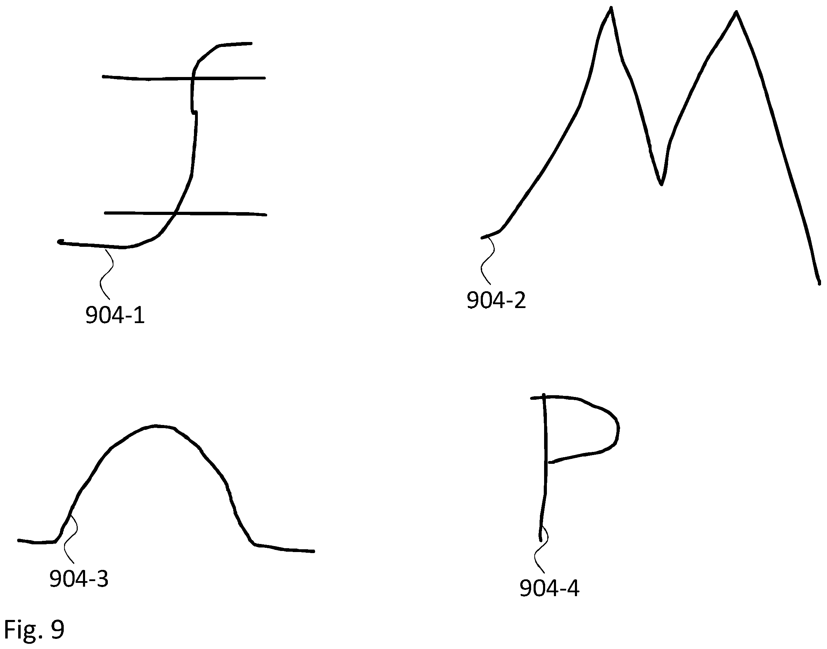

Figure 9 shows possible gesture-based user inputs 904-1, 904-2, 904-3, 904-4, as a user may draw them e.g., on a touchscreen.

The upper left gesture-based user input 904-1 is the same as already shown figures 2 and 3, and comprises an S-shaped curve with two horizontal lines in the upper and lower sections. Such a gesture-based user input 904-1 may e.g., refer to activation of the rise time measurement function.

The upper right gesture-based user input 904-2 comprises an M-shaped curve. Such a gesture-based user input 904-2 may e.g., refer to activation of a specific mathematical function, or a Math-Mode of the measurement application device.

The lower left gesture-based user input 904-3 comprises a horizontal curve that is raised in the center. Such a gesture-based user input 904-3 may e.g., refer to activation of a histogram creation function.

The lower right gesture-based user input 904-4 comprises a P-shaped curve. Such a gesture-based user input 904-4 may e.g., refer to opening the personal persistence settings of the measurement application device.

The processes, methods, or algorithms disclosed herein can be deliverable to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software, and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure, as long as they fall within the scope of the appended claims, and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment.

While exemplary embodiments are described above, it is not intended that these embodiments describe all possible forms of the invention. Other embodiments not detailed in this description might still fall under the scope of the invention, as defined by the appended claims.

### LIST OF REFERENCE SIGNS

- 100, 200, 300, 400, 500: measurement application device
- 101, 201, 301, 401, 501: signal processing module
- 102-1, 102-2, 202-1, 202-2, 302-1, 302-2: measurement signals
- 402-1, 402-2, 502-1, 502-2: measurement signals
- 103, 203, 303, 403, 503: user interface
- 104, 204, 304, 404, 504: gesture-based user input
- 904-1, 904-2, 904-3, 904-4: gesture-based user input
- 105, 205, 305, 405, 505: processor
- 106, 206, 306, 406, 506: machine learning algorithm
- 107, 207, 307, 407, 507: control or configuration information
- 108, 208, 308, 408, 508: controller

- 210, 310: touchscreen
- 211, 311: suggestions of control information, or configuration information

- 212, 312: user feedback

- 315: training data

- 420: user request
- 421: confidence score

- 525: measurement probe

- S1 - S3: method steps

- OSC1: oscilloscope
- HO: housing
- MIP1, MIP2, MIP3, MIP4: measurement input
- SIP: signal processing
- DISP1: display
- OSC: oscilloscope
- VS: vertical system
- SC: signal conditioning
- ATT: attenuator
- DAC1: analog-to-digital converter
- AMP: amplifier
- FI1: filter
- DAC: digital-to-analog converter
- ADC: analog-to-digital converter

- TS: triggering section
- AMP2: amplifier
- FI2: filter
- TS1: trigger system

- HS: horizontal system

- PS: processing section
- ACP: acquisition processing element
- MEM: memory
- PPE: post processing element

- DISP: display

## Claims

1. Measurement application device (100, 200, 300, 400, 500) comprising:
a signal processing module (101, 201, 301, 401, 501) configured to at least one of generate measurement signals (102-1, 102-2, 202-1, 202-2, 302-1, 302-2, 402-1, 402-2, 502-1, 502-2), and acquire measurement signals (102-1, 102-2, 202-1, 202-2, 302-1, 302-2, 402-1, 402-2, 502-1, 502-2);
a user interface (103, 203, 303, 403, 503) configured to acquire gesture-based user input (104, 204, 304, 404, 504); and
a processor (105, 205, 305, 405, 505) coupled to the user interface (103, 203, 303, 403, 503), and executing a machine learning algorithm (106, 206, 306, 406, 506), wherein the machine learning algorithm (106, 206, 306, 406, 506) is configured to analyze received gesture-based user input (104, 204, 304, 404, 504), and to output respective control information (107, 207, 307, 407, 507) for controlling the signal processing module (101, 201, 301, 401, 501) or configuration information (107, 207, 307, 407, 507) for configuration of the signal processing module (101, 201, 301, 401, 501)
wherein:
the gesture-based user input (104, 204, 304, 404, 504) comprises a sketch or the first letter of a measurement function;
and wherein the machine learning algorithm (106, 206, 306, 406, 506) is configured to output at least two suggestions (211, 311) of control information (107, 207, 307, 407, 507), or configuration information (107, 207, 307, 407, 507) based on the gesture-based user input (104, 204, 304, 404, 504);
and wherein the processor (105, 205, 305, 405, 505) is configured to train the machine learning algorithm (106, 206, 306, 406, 506) based on user feedback (212, 312) regarding the suggestions (211, 311).

2. Measurement application device (100, 200, 300, 400, 500) according to claim 1, wherein the user interface (103, 203, 303, 403, 503) comprises a touchscreen (210, 310); and
wherein the machine learning algorithm (106, 206, 306, 406, 506) is configured to analyze gesture-based user input (104, 204, 304, 404, 504) received from a user via the touchscreen (210, 310).

3. Measurement application device (100, 200, 300, 400, 500) according to any one of the preceding claims, wherein the user interface (103, 203, 303, 403, 503) comprises at least one of a movement sensor, and a camera; and
wherein the machine learning algorithm (106, 206, 306, 406, 506) is configured to analyze gesture-based user input (104, 204, 304, 404, 504) acquired via the at least one of the movement sensor, and the camera.

4. Measurement application device (100, 200, 300, 400, 500) according to any one of the preceding claims, wherein the processor (105, 205, 305, 405, 505) is configured to output a user request (420) to a user for repeating the gesture-based user input (104, 204, 304, 404, 504), if the machine learning algorithm (106, 206, 306, 406, 506) calculates a confidence score (421) for the gesture-based user input (104, 204, 304, 404, 504) that is below a predetermined threshold.

5. Measurement application device (100, 200, 300, 400, 500) according to any one of the preceding claims, wherein the machine learning algorithm (106, 206, 306, 406, 506) is configured to output suggestions for at least one control information (107, 207, 307, 407, 507), or configuration information (107, 207, 307, 407, 507) for association with a gesture-based user input (104, 204, 304, 404, 504) based on the respective gesture-based user input (104, 204, 304, 404, 504) in a configuration operating mode of the processor (105, 205, 305, 405, 505).

6. Measurement application device (100, 200, 300, 400, 500) according to claim 5, wherein in the configuration operating mode of the processor (105, 205, 305, 405, 505), the processor (105, 205, 305, 405, 505) is configured to request a user to repeat a gesture-based user input (104, 204, 304, 404, 504) for training the machine learning algorithm (106, 206, 306, 406, 506).

7. Measurement application device (100, 200, 300, 400, 500) according to any one of the preceding claims, further comprising a measurement probe (525) coupled to the signal processing module (101, 201, 301, 401, 501);
wherein the processor (105, 205, 305, 405, 505) is configured to configure the measurement probe (525) based on the configuration information (107, 207, 307, 407, 507), or control information (107, 207, 307, 407, 507).

8. Computer implemented method for operating a measurement application device (100, 200, 300, 400, 500), the method comprising:
acquiring (S1) gesture-based user input (104, 204, 304, 404, 504);
analyzing (S2) the received gesture-based user input (104, 204, 304, 404, 504) with a machine learning algorithm (106, 206, 306, 406, 506); and
outputting (S3) control information (107, 207, 307, 407, 507) for controlling a signal processing module (101, 201, 301, 401, 501) of the measurement application device (100, 200, 300, 400, 500), or configuration information (107, 207, 307, 407, 507) for configuration of the signal processing module (101, 201, 301, 401, 501) based on the analysis result;
wherein
the gesture-based user input (104, 204, 304, 404, 504) comprises a sketch or the first letter of a measurement function;
wherein the machine learning algorithm (106, 206, 306, 406, 506) outputs at least two suggestions (211, 311) of control information (107, 207, 307, 407, 507), or
configuration information (107, 207, 307, 407, 507) based on the gesture-based user input (104, 204, 304, 404, 504), and
wherein the machine learning algorithm (106, 206, 306, 406, 506) is trained based on user feedback (212, 312) regarding the suggestions (211, 311).

9. Computer implemented method according to claim 8, wherein the gesture-based user input (104, 204, 304, 404, 504) is acquired via a touchscreen (210, 310); and/or
wherein the gesture-based user input (104, 204, 304, 404, 504) is acquired via at least one of a movement sensor, and a camera.

10. Computer implemented method according to any one of the preceding method-based claims,
wherein a user request (420) for repeating the gesture-based user input (104, 204, 304, 404, 504) is provided to a user if the machine learning algorithm (106, 206, 306, 406, 506) calculates a confidence score (421) for the gesture-based user input (104, 204, 304, 404, 504) that is below a predetermined threshold.

11. Computer implemented method according to any one of the preceding method-based claims, wherein the machine learning algorithm (106, 206, 306, 406, 506) outputs suggestions for at least one control information (107, 207, 307, 407, 507), or configuration information (107, 207, 307, 407, 507) for association with a gesture-based user input (104, 204, 304, 404, 504) based on the respective gesture-based user input (104, 204, 304, 404, 504) in a configuration operating mode; and/or
wherein in the configuration operating mode a user is requested to repeat a gesture-based user input (104, 204, 304, 404, 504) for training the machine learning algorithm (106, 206, 306, 406, 506).

12. Computer implemented method according to any one of the preceding method-based claims, further comprising configuring a measurement probe (525) that is coupled to the measurement application device (100, 200, 300, 400, 500) based on the configuration information (107, 207, 307, 407, 507), or control information (107, 207, 307, 407, 507).

## Patentansprüche

1. Messanwendungsvorrichtung (100, 200, 300, 400, 500), umfassend:
ein Signalverarbeitungsmodul (101, 201, 301, 401, 501), das für mindestens eines von einem Erzeugen von Messsignalen (102-1, 102-2, 202-1, 202-2, 302-1, 302-2, 402-1, 402-2, 502-1, 502-2) und Erfassen von Messsignalen (102-1, 102-2, 202-1, 202-2, 302-1, 302-2, 402-1, 402-2, 502-1, 502-2) konfiguriert ist;
eine Benutzerschnittstelle (103, 203, 303, 403, 503), die konfiguriert ist, um eine gestenbasierte Benutzereingabe (104, 204, 304, 404, 504) zu erfassen; und
einen Prozessor (105, 205, 305, 405, 505), der an die Benutzerschnittstelle (103, 203, 303, 403, 503) gekoppelt ist, und einen Maschinenlernalgorithmus (106, 206, 306, 406, 506) ausführt, wobei der Maschinenlernalgorithmus (106, 206, 306, 406, 506) konfiguriert ist, um empfangene gestenbasierte Benutzereingaben (104, 204, 304, 404, 504) zu analysieren und um entsprechende Steuerinformationen (107, 207, 307, 407, 507) zum Steuern des Signalverarbeitungsmoduls (101, 201, 301, 401, 501) oder Konfigurationsinformationen (107, 207, 307, 407, 507) für die Konfiguration des Signalverarbeitungsmoduls (101, 201, 301, 401, 501) auszugeben,
wobei:
die gestenbasierte Benutzereingabe (104, 204, 304, 404, 504) eine Skizze oder den ersten Buchstaben einer Messfunktion umfasst;
und wobei der Maschinenlernalgorithmus (106, 206, 306, 406, 506) konfiguriert ist, um mindestens zwei Vorschläge (211, 311) von Steuerinformationen (107, 207, 307, 407, 507) oder Konfigurationsinformationen (107, 207, 307, 407, 507) basierend auf der gestenbasierten Benutzereingabe (104, 204, 304, 404, 504) auszugeben;
und wobei der Prozessor (105, 205, 305, 405, 505) konfiguriert ist, um den Maschinenlernalgorithmus (106, 206, 306, 406, 506) basierend auf Benutzerfeedback (212, 312) bezüglich der Vorschläge (211, 311) zu trainieren.

2. Messanwendungsvorrichtung (100, 200, 300, 400, 500) nach Anspruch 1, wobei die Benutzerschnittstelle (103, 203, 303, 403, 503) einen Touchscreen (210, 310) umfasst; und
wobei der Maschinenlernalgorithmus (106, 206, 306, 406, 506) konfiguriert ist, um eine gestenbasierte Benutzereingabe (104, 204, 304, 404, 504), die von einem Benutzer über den Touchscreen (210, 310) empfangen werden, zu analysieren.

3. Messanwendungsvorrichtung (100, 200, 300, 400, 500) nach einem der vorstehenden Ansprüche, wobei die Benutzerschnittstelle (103, 203, 303, 403, 503) mindestens eines von einem Bewegungssensor und einer Kamera umfasst; und
wobei der Maschinenlernalgorithmus (106, 206, 306, 406, 506) konfiguriert ist, um eine gestenbasierte Benutzereingabe (104, 204, 304, 404, 504), die über den mindestens einen von dem Bewegungssensor und der Kamera erfasst wird, zu analysieren.

4. Messanwendungsvorrichtung (100, 200, 300, 400, 500) nach einem der vorstehenden Ansprüche, wobei der Prozessor (105, 205, 305, 405, 505) konfiguriert ist, um eine Benutzeranforderung (420) an einen Benutzer zum Wiederholen der gestenbasierten Benutzereingabe (104, 204, 304, 404, 504) auszugeben, falls der Maschinenlernalgorithmus (106, 206, 306, 406, 506) einen Konfidenzwert (421) für die gestenbasierte Benutzereingabe (104, 204, 304, 404, 504) berechnet, der unter einem vorbestimmten Schwellenwert liegt.

5. Messanwendungsvorrichtung (100, 200, 300, 400, 500) nach einem der vorstehenden Ansprüche, wobei der Maschinenlernalgorithmus (106, 206, 306, 406, 506) konfiguriert ist, um Vorschläge für mindestens Steuerinformationen (107, 207, 307, 407, 507) oder Konfigurationsinformationen (107, 207, 307, 407, 507) zum Verknüpfen mit einer gestenbasierten Benutzereingabe (104, 204, 304, 404, 504) basierend auf der entsprechenden gestenbasierten Benutzereingabe (104, 204, 304, 404, 504) in einem Konfigurationsbetriebsmodus des Prozessors (105, 205, 305, 405, 505) auszugeben.

6. Messanwendungsvorrichtung (100, 200, 300, 400, 500) nach Anspruch 5, wobei in dem Konfigurationsbetriebsmodus des Prozessors (105, 205, 305, 405, 505) der Prozessor (105, 205, 305, 405, 505) konfiguriert ist, um einen Benutzer aufzufordern, eine gestenbasierte Benutzereingabe (104, 204, 304, 404, 504) zum Trainieren des Maschinenlernalgorithmus (106, 206, 306, 406, 506) zu wiederholen.

7. Messanwendungsvorrichtung (100, 200, 300, 400, 500) nach einem der vorstehenden Ansprüche, ferner umfassend eine Messsonde (525), die an das Signalverarbeitungsmodul (101, 201, 301, 401, 501) gekoppelt ist;
wobei der Prozessor (105, 205, 305, 405, 505) konfiguriert ist, um die Messsonde (525) basierend auf den Konfigurationsinformationen (107, 207, 307, 407, 507) oder Steuerinformationen (107, 207, 307, 407, 507) zu konfigurieren.

8. Computerimplementiertes Verfahren zum Betreiben einer Messanwendungsvorrichtung (100, 200, 300, 400, 500), das Verfahren umfassend:
Erfassen (S1) einer gestenbasierter Benutzereingabe (104, 204, 304, 404, 504);
Analysieren (S2) der empfangenen gestenbasierten Benutzereingabe (104, 204, 304, 404, 504) mit einem Maschinenlernalgorithmus (106, 206, 306, 406, 506); und
Ausgeben (S3) von Steuerinformationen (107, 207, 307, 407, 507) zum Steuern eines Signalverarbeitungsmoduls (101, 201, 301, 401, 501) der Messanwendungsvorrichtung (100, 200, 300, 400, 500) oder von Konfigurationsinformationen (107, 207, 307, 407, 507) für die Konfiguration des Signalverarbeitungsmoduls (101, 201, 301, 401, 501) basierend auf dem Analyseergebnis;
wobei die gestenbasierte Benutzereingabe (104, 204, 304, 404, 504) eine Skizze oder den ersten Buchstaben einer Messfunktion umfasst;
wobei der Maschinenlernalgorithmus (106, 206, 306, 406, 506) basierend auf der gestenbasierten Benutzereingabe (104, 204, 304, 404, 504) mindestens zwei Vorschläge (211, 311) von Steuerinformationen (107, 207, 307, 407, 507) oder Konfigurationsinformationen (107, 207, 307, 407, 507) ausgibt, und
wobei der Maschinenlernalgorithmus (106, 206, 306, 406, 506) basierend auf Benutzerfeedback (212, 312) bezüglich der Vorschläge (211, 311) trainiert wird.

9. Computerimplementiertes Verfahren nach Anspruch 8, wobei die gestenbasierte Benutzereingabe (104, 204, 304, 404, 504) über einen Touchscreen (210, 310) erfasst wird; und/oder
wobei die gestenbasierte Benutzereingabe (104, 204, 304, 404, 504) über mindestens eines von einem Bewegungssensor und einer Kamera erfasst wird.

10. Computerimplementiertes Verfahren nach einem der vorstehenden verfahrensbasierten Ansprüche,
wobei eine Benutzeranforderung (420) zum Wiederholen der gestenbasierten Benutzereingabe (104, 204, 304, 404, 504) bereitgestellt wird, falls der Maschinenlernalgorithmus (106, 206, 306, 406, 506) einen Konfidenzwert (421) für die gestenbasierte Benutzereingabe (104, 204, 304, 404, 504) berechnet, der unter einem vorbestimmten Schwellenwert liegt.

11. Computerimplementiertes Verfahren nach einem der vorstehenden verfahrensbasierten Ansprüche, wobei der Maschinenlernalgorithmus (106, 206, 306, 406, 506) Vorschläge für mindestens Steuerinformationen (107, 207, 307, 407, 507) oder Konfigurationsinformationen (107, 207, 307, 407, 507) für die Verknüpfung mit einer gestenbasierten Benutzereingabe (104, 204, 304, 404, 504) basierend auf der entsprechenden gestenbasierten Benutzereingabe (104, 204, 304, 404, 504) in einem Konfigurationsbetriebsmodus ausgibt; und/oder
wobei in dem Konfigurationsbetriebsmodus ein Benutzer aufgefordert wird, eine gestenbasierte Benutzereingabe (104, 204, 304, 404, 504) zum Trainieren des Maschinenlernalgorithmus (106, 206, 306, 406, 506) zu wiederholen.

12. Computerimplementiertes Verfahren nach einem der vorstehenden verfahrensbasierten Ansprüche, ferner umfassend das Konfigurieren einer Messsonde (525), die an die Messanwendungsvorrichtung (100, 200, 300, 400, 500) gekoppelt ist, basierend auf den Konfigurationsinformationen (107, 207, 307, 407, 507) oder Steuerinformationen (107, 207, 307, 407, 507).

## Revendications

1. Dispositif d'application de mesure (100, 200, 300, 400, 500) comprenant :
un module de traitement de signaux (101, 201, 301, 401, 501) configuré pour au moins l'un parmi générer des signaux de mesure (102-1, 102-2, 202-1, 202-2, 302-1, 302-2, 402-1, 402-2, 502-1, 502-2), et acquérir des signaux de mesure (102-1, 102-2, 202-1, 202-2, 302-1, 302-2, 402-1, 402-2, 502-1, 502-2) ;
une interface utilisateur (103, 203, 303, 403, 503) configurée pour acquérir une entrée utilisateur basée sur un geste (104, 204, 304, 404, 504) ; et
un processeur (105, 205, 305, 405, 505) couplé à l'interface utilisateur (103, 203, 303, 403, 503), et exécutant un algorithme d'apprentissage automatique (106, 206, 306, 406, 506), dans lequel l'algorithme d'apprentissage automatique (106, 206, 306, 406, 506) est configuré pour analyser une entrée utilisateur basée sur un geste (104, 204, 304, 404, 504) reçue, et pour délivrer en sortie des informations de commande (107, 207, 307, 407, 507) respectives pour commander le module de traitement de signaux (101, 201, 301, 401, 501) ou des informations de configuration (107, 207, 307, 407, 507) respectives pour la configuration du module de traitement de signal (101, 201, 301, 401, 501)
dans lequel :
l'entrée utilisateur basée sur un geste (104, 204, 304, 404, 504) comprend un croquis ou la première lettre d'une fonction de mesure ;
et dans lequel l'algorithme d'apprentissage automatique (106, 206, 306, 406, 506) est configuré pour délivrer en sortie au moins deux suggestions (211, 311) d'informations de commande (107, 207, 307, 407, 507), ou d'informations de configuration (107, 207, 307, 407, 507) en fonction de l'entrée utilisateur basée sur un geste (104, 204, 304, 404, 504) ;
et dans lequel le processeur (105, 205, 305, 405, 505) est configuré pour entraîner l'algorithme d'apprentissage automatique (106, 206, 306, 406, 506) en fonction de retours d'utilisateur (212, 312) concernant les suggestions (211, 311).

2. Dispositif d'application de mesure (100, 200, 300, 400, 500) selon la revendication 1, dans lequel l'interface utilisateur (103, 203, 303, 403, 503) comprend un écran tactile (210, 310) ; et
dans lequel l'algorithme d'apprentissage automatique (106, 206, 306, 406, 506) est configuré pour analyser l'entrée utilisateur basée sur un geste (104, 204, 304, 404, 504) reçue d'un utilisateur par l'intermédiaire de l'écran tactile (210, 310).

3. Dispositif d'application de mesure (100, 200, 300, 400, 500) selon l'une quelconque des revendications précédentes, dans lequel l'interface utilisateur (103, 203, 303, 403, 503) comprend au moins l'un parmi un capteur de mouvement et une caméra ; et
dans lequel l'algorithme d'apprentissage automatique (106, 206, 306, 406, 506) est configuré pour analyser l'entrée utilisateur basée sur un geste (104, 204, 304, 404, 504) acquise par l'intermédiaire de l'au moins un parmi le capteur de mouvement, et la caméra.

4. Dispositif d'application de mesure (100, 200, 300, 400, 500) selon l'une quelconque des revendications précédentes, dans lequel le processeur (105, 205, 305, 405, 505) est configuré pour délivrer en sortie une demande utilisateur (420) à un utilisateur pour répéter l'entrée utilisateur basée sur un geste (104, 204, 304, 404, 504), si l'algorithme d'apprentissage automatique (106, 206, 306, 406, 506) calcule un score de confiance (421) pour l'entrée utilisateur basée sur un geste (104, 204, 304, 404, 504) qui est inférieur à un seuil prédéterminé.

5. Dispositif d'application de mesure (100, 200, 300, 400, 500) selon l'une quelconque des revendications précédentes, dans lequel l'algorithme d'apprentissage automatique (106, 206, 306, 406, 506) est configuré pour délivrer en sortie des suggestions pour au moins une information de commande (107, 207, 307, 407, 507), ou une information de configuration (107, 207, 307, 407, 507) pour une association avec une entrée utilisateur basée sur un geste (104, 204, 304, 404, 504) en fonction de l'entrée utilisateur basée sur un geste (104, 204, 304, 404, 504) respective dans un mode de fonctionnement de configuration du processeur (105, 205, 305, 405, 505).

6. Dispositif d'application de mesure (100, 200, 300, 400, 500) selon la revendication 5, dans lequel, dans le mode de fonctionnement de configuration du processeur (105, 205, 305, 405, 505), le processeur (105, 205, 305, 405, 505) est configuré pour demander à un utilisateur de répéter une entrée utilisateur basée sur un geste (104, 204, 304, 404, 504) pour entraîner l'algorithme d'apprentissage automatique (106, 206, 306, 406, 506).

7. Dispositif d'application de mesure (100, 200, 300, 400, 500) selon l'une quelconque des revendications précédentes, comprenant en outre une sonde de mesure (525) couplée au module de traitement de signaux (101, 201, 301, 401, 501) ;
dans lequel le processeur (105, 205, 305, 405, 505) est configuré pour configurer la sonde de mesure (525) en fonction des informations de configuration (107, 207, 307, 407, 507), ou des informations de commande (107, 207, 307, 407, 507).

8. Procédé mis en œuvre par ordinateur permettant de faire fonctionner un dispositif d'application de mesure (100, 200, 300, 400, 500), le procédé comprenant :
l'acquisition (S1) d'une entrée utilisateur basée sur un geste (104, 204, 304, 404, 504) ;
l'analyse (S2) de l'entrée utilisateur basée sur un geste (104, 204, 304, 404, 504) reçue avec un algorithme d'apprentissage automatique (106, 206, 306, 406, 506) ; et
la délivrance en sortie (S3) d'informations de commande (107, 207, 307, 407, 507) pour commander un module de traitement de signaux (101, 201, 301, 401, 501) du dispositif d'application de mesure (100, 200, 300, 400, 500), ou des informations de configuration (107, 207, 307, 407, 507) pour la configuration du module de traitement de signaux (101, 201, 301, 401, 501) en fonction du résultat d'analyse ;
dans lequel l'entrée utilisateur basée sur un geste (104, 204, 304, 404, 504) comprend un croquis ou la première lettre d'une fonction de mesure ;
dans lequel l'algorithme d'apprentissage automatique (106, 206, 306, 406, 506) délivre en sortie au moins deux suggestions (211, 311) d'informations de commande (107, 207, 307, 407, 507), ou d'informations de configuration (107, 207, 307, 407, 507) en fonction de l'entrée utilisateur basée sur un geste (104, 204, 304, 404, 504), et
dans lequel l'algorithme d'apprentissage automatique (106, 206, 306, 406, 506) est entraîné en fonction de retours d'utilisateur (212, 312) concernant les suggestions (211, 311).

9. Procédé mis en œuvre par ordinateur selon la revendication 8, dans lequel l'entrée utilisateur basée sur un geste (104, 204, 304, 404, 504) est acquise par l'intermédiaire d'un écran tactile (210, 310) ; et/ou
dans lequel l'entrée utilisateur basée sur un geste (104, 204, 304, 404, 504) est acquise par l'intermédiaire d'au moins l'un parmi un capteur de mouvement et une caméra.

10. Procédé mis en œuvre par ordinateur selon l'une quelconque des revendications basées sur le procédé précédentes,
dans lequel une demande utilisateur (420) pour répéter l'entrée utilisateur basée sur un geste (104, 204, 304, 404, 504) est fournie à un utilisateur si l'algorithme d'apprentissage automatique (106, 206, 306, 406, 506) calcule un score de confiance (421) pour l'entrée utilisateur basée sur un geste (104, 204, 304, 404, 504) qui est inférieur à un seuil prédéterminé.

11. Procédé mis en œuvre par ordinateur selon l'une quelconque des revendications basée sur le procédé précédentes, dans lequel l'algorithme d'apprentissage automatique (106, 206, 306, 406, 506) délivre en sortie des suggestions pour au moins une information de commande (107, 207, 307, 407, 507), ou information de configuration (107, 207, 307, 407, 507) pour une association avec une entrée utilisateur basée sur un geste (104, 204, 304, 404, 504) en fonction de l'entrée utilisateur basée sur un geste (104, 204, 304, 404, 504) respective dans un mode de fonctionnement de configuration ; et/ou
dans lequel, dans le mode de fonctionnement de configuration, il est demandé à un utilisateur de répéter une entrée utilisateur basée sur un geste (104, 204, 304, 404, 504) pour entraîner l'algorithme d'apprentissage automatique (106, 206, 306, 406, 506).

12. Procédé mis en œuvre par ordinateur selon l'une quelconque des revendications basées sur le procédé précédentes, comprenant en outre la configuration d'une sonde de mesure (525) qui est couplée au dispositif d'application de mesure (100, 200, 300, 400, 500) en fonction des informations de configuration (107, 207, 307, 407, 507), ou des informations de commande (107, 207, 307, 407, 507).
